# EUROPÄISCHE PATENTSCHRIFT

(11) **EP 2 200 951 B1**
(45) Veröffentlichungstag und Bekanntmachung des Hinweises auf die Patenterteilung: **31.08.2016**
(21) Anmeldenummer: 08803779.1
(22) Anmeldetag: 05.09.2008
(51) Int. Cl.: C04B 35/491, C04B 35/493, C04B 35/638, H01L 41/083, H01L 41/187, H01L 41/273, H01L 41/43

(54) **KERAMIKMATERIAL, VERFAHREN ZUR HERSTELLUNG DESSELBEN UND ELEKTROKERAMISCHES BAUELEMENT UMFASSEND DAS KERAMIKMATERIAL**
CERAMIC MATERIAL, METHOD FOR PRODUCING THE SAME, AND ELECTRO-CERAMIC COMPONENT COMPRISING THE CERAMIC MATERIAL
MATÉRIAU CÉRAMIQUE, PROCÉDÉ DE FABRICATION ET COMPOSANT ÉLECTROCÉRAMIQUE CONTENANT LE MATÉRIAU CÉRAMIQUE

(30) Priorität: 07.09.2007 DE 102007042572; 21.09.2007 DE 102007045089
(43) Veröffentlichungstag der Anmeldung: 30.06.2010
(73) Patentinhaber: Epcos AG, 81669 München (DE)
(72) Erfinder: SCHOSSMANN, Michael, A-8530 Deutschlandsberg (AT); KÜGERL, Georg, A-8552 Eibiswald (AT); GLAZUNOV, Alexander, A-8530 Deutschlandsberg (AT)
(74) Vertreter: Epping - Hermann - Fischer
(86) Internationale Anmeldenummer: PCT/EP2008/061810
(87) Internationale Veröffentlichungsnummer: WO 2009/034038

(56) Entgegenhaltungen:
- WO-A-2006/103143
- WO-A-2007/074095
- US-A- 5 500 142

## Beschreibung

Es wird ein Keramikmaterial angegeben, umfassend Bleizirkonat-Titanat, das zusätzlich Nd und Ni enthält.

Weit verbreitete Probleme von Keramikmaterialien sind die Anpassung der morphotropen Phasengrenze, zu geringes Kornwachstum bzw. zu geringe Korngröße und hohe Sintertemperaturen.

WO 2007/074095 A1 offenbart ein piezoelektrisches Keramikmaterial der Zusammensetzung: Pb₁₋ₐRE_{b}AE_{c}[ZrₓTi_{y}(NiₙMOₘ)_{z}]O₃, und US 5,500,142 ein piezoelektrisches Keramikmaterial der allgemeinen Formel: Pb₁₋ₐMₐ{(Ni_{1-b}Zn_{b})_{1/3}Nb_{2/3}}ₓTi_{y}Zr_{z}O₃. mit M = Ba, Sr.

Eine Aufgabe von Ausführungsformen der Erfindung besteht darin, ein Keramikmaterial bereitzustellen, welches über eine angepasste morphotrope Phasengrenze verfügt, wie auch über eine ausreichende Korngröße und bei niedrigeren Temperaturen gesintert werden kann als herkömmliche PZT-Keramiken.

Die Aufgabe wird durch ein Keramikmaterial nach dem Anspruch 1 gelöst. Weitere Ausführungsformen des Keramikmaterials sowie ein Herstellungsverfahren für das Keramikmaterial und elektrokeramische Bauelemente mit dem Keramikmaterial sind Gegenstand weiterer Patentansprüche. Des weiteren wird in einem unabhängigen Anspruch das Verfahren zur Herstellung eines Vielschichtbauelements beansprucht.

Die beschriebene Aufgabenstellung wird durch die Zugabe von Ni und Nd zu einem Keramikmaterial umfassend Bleizirkonat-Titanat gelöst.

Durch die Zugabe von Ni und Nd zum Bleizirkonat-Titanat kann bei der Herstellung die Korngröße der Keramik gesteuert werden. Die Korngröße steht in direktem Zusammenhang mit den piezoelektrischen Eigenschaften der Keramik.
Des weiteren kann die Herstellung der Keramik bei niedrigeren Temperaturen erfolgen, was eine Kombination mit anderen, bei höheren Temperaturen nicht beständigen Werkstoffen / Materialien bereits während des Herstellungsverfahrens des Keramikmaterials ermöglicht.

Durch geeignete Wahl des Zirkonat- und Titanatanteils in der Keramik kann die morphotrope Phasengrenze der Keramik angepasst werden, was sich wiederum positiv auf die piezoelektrischen Eigenschaften der Keramik auswirkt.

Die mechanischen Spannungen einer Bleizirkonat-Titanat-Keramik (PZT-Keramik) sind eng mit dem Gefüge insbesondere der mittleren Korngröße verknüpft. Die dielektrischen und elektromechanischen Eigenschaften von PZT-Keramiken werden wesentlich von der Domänengröße bestimmt. Diese wiederum steht in Abhängigkeit mit der Korngröße. Domänen in ferroelektrischen Keramiken entstehen aufgrund der am ferroelektrischen Umwandlungspunkt auftretenden mechanischen Spannung. Materialien, in denen es elektrische Dipole gibt, die durch äußere Felder in ihrer Lage verändert werden können, nennt man Ferroelektrika. Die Anzahl der Domänen pro Volumeneinheit nimmt mit abnehmender Korngröße zu. Damit verbunden verringert sich die Größe der Domänen. Diese Verringerung der Domänengröße hat Auswirkungen auf die elastischen Spannungsfelder. Die veränderte Domänengröße hat Konsequenzen für die Materialeigenschaften der Keramik. Somit ist es erstrebenswert, die Korngröße bzw. das Kornwachstum steuern zu können.

Gemäß einer weiteren Ausführungsform der Erfindung weist die Bleizirkonat-Titanat-Keramik ein Perowskitgitter auf, welches sich durch die allgemeine Formel ABO₃ beschreiben lässt, wobei A für die A-Plätze und B für die B-Plätze des Perowskitgitters stehen.

Das Perowskitgitter zeichnet sich durch eine hohe Toleranz gegenüber Dotierungen und Leerstellen aus.

Die Perowskitstruktur des Bleizirkonat-Titanats (PZT) lässt sich durch die allgemeine Formel ABO₃ beschreiben. Eine Elementarzelle des PZT-Kristallgitters lässt sich durch einen Kubus beschreiben. Die A-Plätze sind durch Pb²⁺-Ionen besetzt, welche auf den Ecken des Kubus sitzen. In der Mitte jeder Kubusfläche sitzt jeweils ein O²⁻-Ion. Im Zentrum des Kubus befindet sich ein Ti⁴⁺-Ion oder Zr⁴⁺-Ion. Diese Struktur weist eine hohe Toleranz gegenüber Substitution der Metallionen durch andere Metallionen und Fehlstellen auf, weshalb sie sich gut dotieren lässt.

Je nach Größenunterschied zwischen dem durch Dotierung eingeführten Ion und dem ersetzten Ion kann es zur Verzerrung des hoch-symmetrischen Koordinationspolyeders kommen.

Erfindungsgemäß wird das Keramikmaterial durch die folgenden allgemeinen Formeln beschrieben:
- für

   y =< x/2: a PbO + (Pb_{1-3x/2+y}□_{x/2-y}Ndₓ) ((Zr_{1-z}Ti_{z})_{1-y}Ni_{y})O₃,
- für

   y > x/2: a PbO + (Pb₁₋ₓNdₓ)((Zr_{1-z}Ti_{z})_{1-y} Ni_{y})O_{3-y+x/2}◊_{y-x/2},
wobei 0=<a<1, 0<x<1, 0<y<1, 0<z<1 ist und a für einen Überschuss an PbO in der Einwaage steht, □ eine Pb-Leerstelle und ◊ eine 0-Leerstelle darstellt.

Hierbei werden in Abhängigkeit von dem Verhältnis Ni zur Nd zwei Fälle unterschieden. In ersten Fall, für y =< x/2, wird für jeweils zwei Nd-Atome, welche jeweils einen A-Platz in der Perowskitstruktur einnehmen, eine Pb-Leerstelle gebildet, da die zwei Nd-Ionen aufgrund ihrer dreifach positiven Ladung die Ladung von drei zweifach positiv geladenen Pb-Ionen kompensieren.

Jedes Ni-Atom, welches in diesem ersten Fall einen B-Platz einnimmt kompensiert aufgrund seiner nur zweifach positiven Ladung im Vergleich zu einer vierfach positiven Ladung eines ausgetauschten Zr- oder Ti-Ions eine Pb-Leerstelle anstatt eine 0-Leerstelle auszubilden, was auf Grund des Verhältnisses von Nd zu Ni in diesem Fall immer möglich ist, wodurch es zu keiner Ausbildung von Sauerstoffleerstellen kommt.

Im zweiten Fall, für y > x/2, wird für jedes Ni-Atom, welches einen B-Platz einnimmt zur Ladungserhaltung eine 0-Leerstelle gebildet. Da das Ni-Ion nur über zwei positive Ladungen verfügt, dieses aber entweder Ti oder Zr ersetzt, welche über vier positive Ladungen verfügen, wird zur Ladungserhaltung eine Sauerstoffleerstelle ausgebildet. Die Ausbildung einer Sauerstoffleerstelle gleicht die zwei "negativen Ladungen", die durch die Akzeptordotierung entstanden sind, aus. Auf Grund des Verhältnisses von Nd zu Ni kommt es zu keiner Ausbildung von Pb-Leerstellen, da alle Pb-Leerstellen durch Sauerstoffleerstellen kompensiert werden.

Die verschiedenen Möglichkeiten der Dotierung lassen sich anhand der Wertigkeit des Dotierungsions klassifizieren. Die isovalente Dotierung, also der Ersatz eines Ions durch ein anderes Ion mit gleicher Wertigkeit wirkt sich nicht auf mögliche Leerstellen im Keramikmaterial aus. Ersetzen niederwertige Kationen (Akzeptoren) Kationen mit einer höheren Wertigkeit, so werden Leerstellen im Anionengitter erzeugt. Höhervalente Kationen (Donatoren) verursachen, wenn sie niederwertigere Kationen ersetzen Leerstellen im Kationengitter. Die Dotierung mit Akzeptoren und Donatoren führt jeweils zu charakteristischen Änderungen der Materialeigenschaften. Akzeptordotierte Keramiken werden auch als "harte", donatordotiere Keramiken als "weiche" Keramiken bezeichnet.

In einem Ausführungsbeispiel der Erfindung nimmt Nd A-Plätze im Perowskitgitter ein.

Eine Dotierung mit Nd³+ auf den A-Plätzen stellt eine Donator-Dotierung dar. Aufgrund des Ionenradius von Neodym wird dieses auf den Pb²⁺-Plätzen eingebaut. Der Ladungsausgleich erfolgt durch die entsprechende Bildung von Pb-Leerstellen. Die Auswirkung der Dotierung sind metrische Änderungen des Gitters und die Beeinflussung länger wirkenden Wechselwirkungen zwischen den Elementarzellen.

In einem weitern Ausführungsbeispiel nimmt Ni B-Plätze im Perowskitgitter ein.
Dies stellt eine B-Platz Akzeptor-Dotierung dar, über welche u. a. das Korngrößenwachstum gesteuert werden kann.

Diese Dotierung wirkt sich auf das Kornwachstum des Materials aus, welches von der Konzentration der eingebrachten Dotierung abhängig ist. Kleine Dotierungsmengen tragen hierbei zum Kornwachstum bei, wohingegen zu große Mengen an Dotierungsionen das Kornwachstum hemmen können. Die piezoelektrischen Qualitäten von PZT-Keramiken verschlechtern sich mit einer Verringerung der Korngröße. Die remanente Polarisation, der Anteil der Polarisation, der beim Abschalten des elektrischen Feldes erhalten bleibt, sinkt und damit verbunden verschlechtern sich die piezoelektrischen Eigenschaften und der Kopplungsfaktor.

In einer weiteren Ausführungsform des Keramikmaterials gelten für die Indizes folgende Bereiche: 0=<a=<0,05, 0,0001=<x=<0,06, 0,0001=<y=<0,06 und 0,35=<z=<0,6.
Die Körner des Keramikmaterials weisen innerhalb dieser Parameterbereiche eine gute Größe auf. Die morphotrope Phasengrenze wir über den Parameter z angepasst.

In einer weiteren Ausführungsform des Keramikmaterials gelten für die Indizes folgende Bereiche: 0=<a=<0,05, 0,005=<x=<0,03, 0,005=<y=<0,03 und 0,35=<z=<0,6.
Die Körner der Keramik weisen bei dieser Keramik eine sehr gute Größe auf. Die morphotrope Phasengrenze wir über den Parameter z angepasst.

Die aufgrund des Ladungsausgleiches gebildeten Pb-Leerstellen im Fall von y=<x/2 führen zu einer Verringerung der Gitterverzehrung. Die veränderten Stabilitätsbedingungen führen zu einer Verschiebung der morphotropen Phasengrenze (MPG). Der Bereich eines Phasendiagramms in dem sich zwei Bereiche unterschiedlicher Phasengeometrie treffen bzw. koexistieren, beispielsweise tetragonal und rhomboedrisch, wird als morphotrope Phasengrenze bezeichnet. In der tetragonalen Phase ist der Kubus entlang einer Achse verzerrt, die durch zwei gegenüberliegende Sauerstoffatome führt, bei der rhomboedrischen Phase liegt die Achse auf der Raumdiagonalen des Kubus.

Diese Verschiebung ist umso größer je höher die Konzentration der Dotierung ist. Die morphotrope Phasengrenze für PZT mit 2 mol% Nd-Dotierung liegt bei einem Zr-Ti-Molverhältnis von 54/46 bis 56/44, wohingegen bei einer undotierten PZT-Keramik die morphotrope Phasengrenze bei einem fast ausgeglichen Zr-Ti-Verhältnis liegt. Die Verschiebung der MPG macht eine neue Anpassung der Phasengrenze nötig, wenn die Keramik gute piezoelektrische Eigenschaften aufweisen soll.

Die Eigenschaften von Donator dotierten PZT-Materialien, wie sie in dem Fall vorliegen, wo Nd Pb-Plätze einnimmt, basiert im Wesentlichen auf einer erhöhten Domänenbeweglichkeit, die durch die Pb-Leerstellen, wie sie im Fall von y =< x/2 vorliegen, verursacht wird. Die Leerstellen führen dazu, dass sich die Domänen bereits von kleinen elektrischen Feldern beeinflussen lassen. Unter Domänen versteht man Bereiche in der Keramik mit gleicher Polarisation. Dies führt im Vergleich mit undotierten PZT-Keramiken zu einer leichteren Verschiebbarkeit der Domänengrenzen und somit zu höheren Dielektrizitätskonstanten, piezoelektrischen Konstanten und höheren Kopplungsfaktoren.

Die im Ausführungsbeispiel vorhandene Kombination von Akzeptor- und Donator-Dotierung führt dazu, dass die negativen Eigenschaften, welche auftreten, wenn die Keramik mit nur einer der beiden Dotierungsarten dotiert wurde, kompensiert werden. Würde beispielsweise nur eine Akzeptor-Dotierung vorliegen so führt dies oft zu sinkenden dielektrischen und piezoelektrischen Konstanten und einem sinkenden Kopplungsfaktor, d.h. die Konstanten liegen unter denen der undotierten Keramik. Liegt nur eine Donator-Dotierung vor, so wird das Kornwachstum gehemmt, und die Körner der Keramik erreichen nicht die gewünschte Größe. Die in den Ausführungsbeispielen vorhandene Kombination der Dotierungen hebt sich jedoch in diesen Punkten positiv von der undotierten Keramik ab. Sie weißt sowohl bessere piezoelektrische Konstanten auf, wie auch ein besseres Kornwachstum, welches auch noch bei tieferen Temperaturen erreicht wird, als bei undotierten PZT-Keramiken.

In kleinkörnigen Materialen sind die Domänengrenzen häufig an den Korngrenzen lokalisiert und können aufgrund der Fixierung an diesen Korngrenzen so nicht zu den piezoelektrischen Eigenschaften beitragen. Die innere Spannung kann sich auf die Struktur des Kristallgitters, und die Stabilität von Phasen auswirken. Deshalb ist es erstrebenswert das Kornwachstum gezielt steuern zu können. Dies soll unter anderem über die Dotierung der PZT-Keramik erfolgen.

Ausführungsformen der Erfindung können für die Anwendung als Sensor oder Aktuator in vielfältigen Geometrien hergestellt werden. Aus technologischen Gründen ergeben sich bei der Herstellung Besonderheiten im Gefüge, wie zum Beispiel unterschiedliche Korngrößen oder unterschiedliche Phasengrenzen. Da sich aber diese Parameter auf die Eigenschaften eines ferroelektrischen Materials auswirken ist es erstrebenswert diese Parameter entsprechend auf die Zusammensetzung anzupassen. Bei der morphotropen Phasengrenze (MPG) ist besonderes die Koexistenz von rhomboedrischen neben tetragonalen Phasen von Interesse. Diese steht wiederum auch in direkten Zusammenhang mit der Korngröße. In einer erfindungsgemäßen Ausführungsform der Keramik ist eine Anpassung der Phasengrenze über den Index z, über den sich das Ti-Zr-Verhältnis steuern lässt, möglich.

Messungen der piezoelektrischen Eigenschaften zeigen dass unterhalb einer Grenzkorngröße von etwa 1 µm die Korngröße einen starken Einfluss auf das Gefüge hat. So verschiebt sich die MPG mit abnehmender Korngröße zur titanreicheren Zusammensetzungen. Innere Spannungen müssen als Ursache für diese Verschiebung angenommen werden. Mit abnehmender Korngröße kann eine zunehmende Klemmung beobachtet werden. Diese Klemmung wiederum ist die Ursache für innere Spannungen welche die piezoelektrischen Eigenschaften des Materials beeinflussen. Die Klemmungen sind auf die Verzehrung des Kristallgitters im Bereich an den Domänenwände zurückzuführen. Die bei kleinen Körnern ausgebildeten Domänen im Nanometerbereich sind fast vollständig verspannt. Diese Verspannungen führen zu einer Deformation der Elementarzellen, und zur Destabilisierung der tetragonalen Struktur was wiederum zur Verschiebung der MPG führt. Aus diesen Gründen ist es erstrebenswert, über eine entsprechende Dotierung der PZT-Keramik Einfluss auf die Korngröße nehmen zu können.

Für die technische Anwendung solcher feinkörnigen Keramiken muss diese Verschiebung der Phasengrenze berücksichtigt werden. Dies macht eine Anpassung der MPG notwendig. Eine solche Anpassung kann über eine Dotierung der Bleizirkonat-Titanat-Komponente des Keramikmaterials erfolgen. Eine solche Dotierung wirkt sich auch auf die Sintereigenschaften wie auf das Kornwachstum aus. Erfolgt die Dotierung nur mit Nd wirkt dieses als Wachstumsinhibitor bezüglich der Korngrößen, so dass Keramiken mit hinreichend gutem Gefüge nur bei erhöhten Sintertemperaturen erreicht werden können. Diese hohen Temperaturen haben jedoch deutliche Nachteile: die Prozesszeiten verlängern sich, es kann zu Versinterungen kommen und die Innenelektroden von elektrokeramischen Bauelementen mit diesen Keramikmaterialien müssen aus teuren Edelmetallen gefertigt werden. Es ist also erstrebenswert die Sintertemperatur möglichst niedrig zu halten. Die Dotierung mit Nd und Ni ermöglicht es trotz niedrigen Temperaturen zu gewünschten Korngrößen zu kommen.

Aufgrund der angeführten Eigenschaften eignet sich die Keramik sehr gut zur Fertigung und zum Einsatz in elektrokeramischen Bauelementen.

Durch die Herabsetzung der Sintertemperatur werden auch Möglichkeiten zur Kombination mit anderen Werkstoffen eröffnet, welche bei den höheren Sintertemperaturen, welche bei den nicht erfindungsgemäßen PZT-Keramiken von Nöten waren, nicht möglich waren. Beispielsweise mit Metallen wie Kupfer, dessen Schmelzpunkt bei 1083 °C liegt. Hiermit eröffnen sich neue Möglichkeiten beispielsweise auf dem Gebiet der piezoelektrischen Aktuatoren.

Eine Reduktion der Sintertemperatur durch die Zugabe von Ni eröffnet die Möglichkeit piezoelektrische Aktuatoren aus der Nd und Ni umfassenden Keramik mit Innenelektroden, die entweder nur einen geringen Anteil an seltenen Edelmetall (z.B. Pd) oder gar keinen Anteil derselben enthalten, herzustellen. Somit eignen sich bestimmte Ausführungsformen der erfindungsgemäßen Keramik auch für Aktuatoren mit Innenelektroden mit niedrigem Schmelzpunkt. So zum Beispiel für den Fall, dass die Innenelektroden ein Material umfassen, das ausgewählt ist aus: Cu, Pd, Ag oder einer Legierung aus diesen Metallen.

Ein Ausführungsform der Erfindung ist ein piezoelektrischer Aktuator. Dieser umfasst in einer bevorzugten Ausführungsform mindestens zwei Schichten des mit Ni und Nd dotierten PZT-Keramikmaterials zwischen denen eine Innenelektrode vorhanden ist. Diese Innenelektrode könnte beispielsweise aus Cu, Pd, Ni, Ag oder einer Legierung aus diesen Metallen gefertigt sein.

Der Einbau von Ni in das PZT-Gitter kann die Reaktion zwischen piezoelektrischer Keramik und dem Metall der Innenelektrode, die während des Sintervorgangs bei hohen Temperaturen stattfinden, reduzieren oder sogar unterbinden. Nimmt man beispielsweise einen Aktuator mit Cu-Innenelektrode aus einem keramischen Material, das nicht mit Ni dotiert wurde, gemäß der Formel Pb_{1-3/2a}Nd_{a 1/2a}(Zr₁₋ₓTiₓ)O₃, wobei 0<a<1, 0<x<1 und eine Pb-Leerstelle darstellt, enthält das Kristallgitter auf Grund der unterschiedlichen Oxidationsstufen von Pb und Nd, 2+ gegenüber 3+, ½ a Pb-Leerstellen. Diese Leerstellen ermöglichen eine Diffusion der Cu-Ionen aus den Innenelektroden in die Keramik, wo es zu einem Einbau der Cu-Ionen in das Kristallgitter kommt. Dieses Problem wird in einer Ausführungsform der Erfindung durch den Einbau von Ni auf B-Plätzen des Kristallgitters vermindert bzw. gelöst. Die damit verbundene Kompensation der Pb-Leerstellen auf den A-Plätzen reduziert das Bestreben des Kupfers aus den Innenelektroden in die Keramik zu diffundieren, was eine Wanderung der Cu-Ionen reduziert oder sogar komplett unterbindet.

Die ganz oder teilweise unterbundene Diffusion der Cu-Ionen hat unterschiedliche Vorteile für die aus den erfindungsgemäßen Keramiken gefertigten elektrokeramischen Bauelemente. Erstens verlieren die Innenelektroden in diesem Fall kein Material und können eine durchgängige Schicht bilden, was für eine bessere Leitfähigkeit der Innenelektroden sorgt.

Zweitens führt die Unterbindung von Reaktionen zwischen Innenelektrodenmetall und der Keramik zu einer Reduktion von Benetzungskraft zwischen Innenelektrode und Keramik. Eine schwächere Benetzung sorgt dafür, dass Risse, die während der Polung oder dem Betrieb vom piezoelektrischen Aktuator im Grundkörper des Aktuators entstehen, nur an der Grenze zwischen Innenelektrode und Keramik bleiben und nicht durch darüber hinaus sich durch die Keramik ausdehnen. Dies verlängert die Lebensdauer des piezoelektrischen Aktuators.

Dem Übergangsbereich zwischen tetragonaler und rhomboedrischer Phase kommt bei den Ausführungsformen der Keramik besondere Bedeutung zu. Es kommt in diesem zu einer konzentrationsabhängigen Umwandlung zwischen zwei Kristallstrukturen im Keramikmaterial. Eine solche Phasengrenze wird nach Jaffe als "morphotrop" bezeichnet. Die Materialeigenschaften zeigen in diesem Bereich einige Besonderheiten, so dass sie für die technische Anwendung besonders interessant sind. Keramiken zeigen an Phasenübergängen besonders gute piezoelektrische Eigenschaften. Einige Materialkonstanten die das piezoelektrische Verhalten der PZT-Keramik entscheidend beeinflussen zeigen an der morphotropen Phasengrenze gute Werte, z. B. deutliche Maxima, wie beispielsweise die Dielektrizitätskonstante εᵣ, die piezoelektrische Ladungskonstante d₃₃ und der Kopplungsfaktor k.

Die relative Dielektrizitätskonstante εᵣ ist das Verhältnis aus der absoluten Permittivität des Keramikmaterials und der Permittivität im Vakuum, wobei die absolute Permittivität ein Maß für die Polarisierbarkeit im elektrischen Feld darstellt. Die Wirksamkeit des Piezoeffekts wird durch die piezoelektrische Ladungskonstante dᵢⱼ gekennzeichnet, die das Verhältnis der erzeugten Ladungsdichte zur mechanischen Verformung darstellt. Die Richtungsabhängigkeit des Parameters wird durch die entsprechenden Indizes angegeben. Der Index i der piezoelektrischen Ladungskonstanten gibt die Richtung des elektrischen Feldes an, der Index j die Richtung der Deformation, mit der der Kristall auf das Feld reagiert. Hierbei steht eine 1 für die x-Richtung, 2 für die y-Richtung und 3 für die z-Richtung. Die piezoelektrische Ladungskonstante d₃₃ bezeichnet somit das longitudinale Dehnungsverhalten in Richtung der z-Achse. Der Kopplungsfaktor k ist ein Maß für den Grad des piezoelektrischen Effektes. Er beschreibt das Vermögen eines piezoelektrischen Materials aufgenommene elektrische Energie in mechanische Energie umzuwandeln und umgekehrt. Hierbei steht k₃₃ für den Kopplungsfaktor der Longitudinalschwingung. Beim Longitudinal-Effekt ist die polare Achse des Kristalls kolinear zur Deformationsrichtung.

Vergleicht man die piezoelektrische Ladungskonstante d₃₃ der nur mit Nd dotierten Keramik 0,015 PbO + (Pb_{0,97 0,01}Nd_{0,02}) (Zr_{0,5515}Ti_{0,4485})O₃ (d₃₃: 690 pm/V) mit dem entsprechenden Ausführungsbeispiel einer erfindungsgemäßen Keramik, die zusätzlich Ni aufweist 0,015 PbO + (Pb_{0,975 0,005}Nd_{0,02}) (Zr_{0,5515}Ti_{0,4485})_{0,995}Ni_{0,005})O₃ (d₃₃: 740 pm/V), so stellt man einen deutlichen Anstieg des Wertes fest, was eine größere Dehnung bei gleicher angelegter Spannung bedeutet. Die verbesserten piezoelektrischen Eigenschaften steigern somit die Effizienz der entsprechenden Ausführungsbeispiele, in denen diese Keramik zum Einsatz kommt.

Als Ursache der Maxima physikalischer Eigenschaften an der MPG gilt die Koexistenz der rhomboedrischen und der tetragonalen Phase. Diese Koexistenz begünstigt die Ausrichtung von Domänen im elektrischen Feld und verbessert so die Polarisierbarkeit der Keramik. Dies unterstreicht nochmals die Bedeutung und Sonderstellung der MPG in der PZT-Keramik.

Ausführungsformen des erfindungsgemäßen Keramikmaterials eignen sich aufgrund der guten piezoelektrischen Eigenschaften für den Einsatz in beispielsweise Vielschichtbauelementen.

Werden mehrere Keramikschichten und Innenelektroden abwechselnd übereinander angeordnet, so erhält man ein piezoelektrisches Vielschichtbauelement. Abwechselnd ist in diesem Zusammenhang so zu verstehen, das immer auf eine bestimmte Zahl von Keramikschichten eine Innenelektrode folgt.

Gegenstand von weiteren Ausführungsformen der Erfindung ist auch ein Herstellungsverfahren für das Keramikmaterial.

Das Verfahren zur Herstellung des Keramikmaterials umfasst folgende Schritte:
A1) Herstellung eines Keramik-Rohstoffgemisches durch Zerkleinern und Mischen von Ausgangsmaterialien enthaltend Pb, Zr, Ti, Nd und Sauerstoff, B1) Einbringen von Ni oder einer Ni-haltigen Verbindung, C1) Kalzinieren des Rohstoffgemisches, und D1) Sintern zur Keramik.

Hierbei können die Ausgangsmaterialien als Oxide vorliegen. Die Ausgangsmaterialien können aber auch in Form von beispielsweise Metallcarbonaten, Metallhydrogencarbonaten oder metallorganischen Verbindungen vorliegen.

Die Elemente Zr und Ti können auch in Form eines Precursors wie (Zr,Ti)O₂ als Ausgangsmaterial eingesetzt werden.
Die Elemente Pb, Zr, Ti und Nd werden in ihren entsprechenden Ausgangsverbindungen entsprechend der stöchiometrischen Verhältnisse der Elemente im herzustellenden Keramikmaterial gemischt.

Die Zugabe von Nd erfolgt in einem Bereich von 0,01 bis 6 mol%, wobei der Bereich von 0,5 bis 3 mol% bevorzugt ist.

Das Einbringen von Ni oder Ni-haltigen Verbindungen kann sowohl vor oder auch erst nach dem Kalzinieren erfolgen.

Die Zugabe von Ni erfolgt in einem Bereich von 0,01 bis 6 mol%, wobei der Bereich von 0,5 bis 3 mol% bevorzugt ist. Dabei wird Ni bzw. die Ni-haltige Verbindung ebenfalls entsprechend des stöchiometrischen Verhältnisses von Ni im bezug auf die anderen Elemente im herzustellenden Keramikmaterial hinzugegeben.

Das Keramik-Rohstoffgemisch wird im Verfahrensschritt C1) bei einer Temperatur kalziniert, die zwischen 850 und 970°C liegt. Das ermöglicht der Keramik die Bildung von Mischkristallphasen.

Die "rohe" oder auch als "grün" bezeichnete Keramik wird im Verfahrensschritt D1) gesintert. Die Sintertemperatur liegt hierbei beispielsweise zwischen 950 und 1070 °C. Somit liegt sie unter dem Schmelzpunkt von Kupfer (1083 °C), was es ermöglicht, die Innenelektroden eines piezoelektrischen Aktuators beispielsweise vollständig aus Kupfer zu fertigen, oder aus Legierungen, deren Schmelzpunkt in dem Bereich von Kupfer liegt.

Zur Formgebung kann die Mischkristallphase, die durch das Kalzinieren entsteht, in einem zwischengelagerten zusätzlichem Verfahrensschritt erneut gemahlen werden und durch Zugabe eines Binders in eine Keramikmasse überführt werden. Diese kann dann in die gewünschte Form gebracht werden, beispielsweise Grünfolien. Da der Binder im Endprodukt nicht erwünscht ist, sollte dieser thermisch bzw. hydrothermisch abbaubar sein. Hierzu eignen sich beispielsweise Binder auf Polyurethanbasis. Der Binder sollte jedoch vor dem Sintern ein einem zusätzlichen thermischen Prozess entfernt werden. Das Entbindern soll das Einbrennen von unerwünschten beispielsweise organischen Stoffen verhindern.

Es wird des weiteren ein Herstellungsverfahren für ein Vielschichtbauelement beansprucht, welches die erfindungsgemäße Keramik umfasst.

Das Verfahren zur Herstellung des Vielschichtbauelements umfasst folgende Verfahrensschritte: A2) Bereitstellen von keramischen Grünfolien die gemäß einem der vorher beschriebenen Verfahren hergestellt werden, B2) Übereinanderschichten der keramischen Grünfolien zu einem Stapel, C2) Verfestigen des Stapels durch Laminieren, wodurch Grünteile entstehen, D2) Entbindern der Grünteile und E2) Sintern der Grünteile.

Die keramischen Grünfolien enthalten dabei bereits Ausgangsmaterialien enthaltend Pb, Zr, Ti, Nd, Sauerstoff und Ni. Das Ni kann dabei bereits dem ursprünglichen Gemisch der Ausgangsmaterialien entweder vor oder nach dem Kalzinieren beigemischt worden sein.

Das Laminieren im Verfahrensschritt C2) kann beispielsweise mit einer Presskraft von 100 bis 130 Tonnen erfolgen. Die Presskraft kann hierbei auf den Binder-Typ abgestimmt sein.

Das Entbindern im Verfahrensschritt D2) kann unter inerter Atmosphäre bei 550°C erfolgen, was beispielsweise bei Kupferinnenelektroden bevorzugte Bedingungen wären. Das Entbindern kann aber auch unter Luft-Atmosphäre geschehen. Die Temperatur ist hierbei beispielsweise auf das Bindermaterial und das Material der Innenelektroden abgestimmt.

Das Sintern im Verfahrensschritt E2) kann beispielsweise über 4 Stunden bei einer Temperatur bis zu 1070°C erfolgen. Ein möglicher Sintertemperaturbereich umfasst 960 bis 1100 °C, wobei auch höhere Temperaturen zum Erfolg führen können. Der Bereich von 980 bis 1040 °C ist jedoch bevorzugt.

Für das Sintern im Verfahrensschritt E2) kann ein Gasgemisch verwendet werden, welches Stickstoff, Wasserstoff und Wasserdampf umfasst.

Umfasst das Vielschichtbauelement Innenelektroden, so kann das Material für die Innenelektroden zwischen den Verfahrensschritten A2) und B2) auf die Grünfolien aufgebracht, beispielsweise aufgedruckt, werden.

Es wird des weiteren ein weiteres Herstellungsverfahren für ein Vielschichtbauelement beansprucht, bei dessen Herstellung eine weitere Ausführungsform der Keramik entsteht.

Dieses weitere Herstellungsverfahren umfasst folgende Verfahrensschritte: A3) Herstellung eines Keramik-Rohstoffgemisches durch Zerkleinern und Mischen von Ausgangsmaterialien enthaltend Pb, Zr, Ti, Nd und Sauerstoff, B3) Kalzinieren des Keramik-Rohstoffgemisches, C3) Zugabe eines Binders zu dem Keramik-Rohstoffgemisch aus B3), D3) Formen von Grünfolien aus dem Gemisch aus C3), E3) Bedrucken der Grünfolien aus D3) mit Innenelektroden, wobei das Material der Innenelektroden Ni umfasst, F3) Übereinanderschichten von einer Vielzahl der keramischen Grünfolien aus E3) zu einem Stapel, G3) Verfestigen des Stapels durch Laminieren, wodurch Grünteile entstehen, H3) Entbindern der Grünteile und I3) Sintern der Grünteile, wobei ein Teil des Ni aus den Innenelektroden in das Keramikmaterial übergeht und in dieses eingebaut wird.

Hierbei können im Verfahrensschritt F3) zwischen die Grünfolien aus E3) auch Grünfolien entsprechend D3) geschichtet werden, also Grünfolien die nicht mit Elektrodenmaterial bedruckt wurden.

Der Verfahrensschritt C3) kann einen Polyurethan-Binder umfassen, welcher thermisch oder hydrothermisch abbaubar sein kann.

Das Material der Innenelektroden kann metallisches Ni oder Ni-Oxid umfassen. Durch das Bedrucken der Grünfolien im Verfahrensschritt E3) haben die Ni-Ionen bereits die Möglichkeit in das Keramikmaterial zu diffundieren.

Das Laminieren im Verfahrensschritt G3) kann mit einer Presskraft von 100 bis 130 Tonnen erfolgen. Durch den Druck werden Grünteile geformt.

Das Entbindern im Verfahrensschritt H3) kann unter inerter oder Luft-Atmosphäre bei 550 °C erfolgen. Bei diesem Verfahrenschritt muss die Temperatur so gewählt werden, dass die unerwünschten, oftmals organischen Bestandteile die unter anderem durch den Binder eingebracht wurden heraus gebrannt werden. Somit wird die Entbindertemperatur bevorzugt auf den Binder-Typ abgestimmt. Aber auch das Material der Innenelektroden spielt eine Rolle bei der Wahl der Entbindertemperatur. Die thermische Behandlung kann auch zur Diffusion von Ni aus dem Elektrodenmaterial in die Keramik beitragen.

Das Sintern im Verfahrensschritt I3) kann über 4 Stunden bei einer Temperatur bis zu 1070 °C erfolgen. Ein möglicher Sintertemperaturbereich umfasst 960 bis 1100 °C, wobei der Bereich von 980 bis 1040 °C bevorzugt ist, aber auch Temperaturen über 1100 °C zum gewünschten Ziel führen können.

Für das Sintern im Verfahrensschritt I3) kann ein Gasgemisch verwendet werden, das Stickstoff, Wasserstoff und Wasserdampf umfasst. Während des Sinterprozess wandern Ni-Ionen aus dem Innenelektrodenmaterial in die Keramik, wo sie dann auf B-Plätzen eingebaut werden.

Das Vielschichtbauelement kann in weiteren Schritten geschliffen und poliert werden. Im Bereich der austretenden Innenelektroden kann eine Kontaktierung, beispielsweise mit einer Kupferpaste, erfolgen. Nach dem Einbrennen der Paste kann das Vielschichtbauelement mittels der üblichen Bond-Technologie nun mit Drähten versehen werden. Hieraus resultiert somit ein piezoelektrischer Aktuator.

## Patentansprüche

1. Keramikmaterial umfassend Bleizirkonat-Titanat,
das zusätzlich Nd und Ni enthält mit einer Zusammensetzung gemäß den folgenden Formeln:
- für
y ≤ x/2: a PbO + (Pb_{1-3x/2+y}□_{x/2-y}Ndₓ) ((Zr_{1-z}Ti_{z})_{1-y} Ni_{y})O₃,
- für
y > x/2: a PbO + (Pb₁₋ₓNdₓ) ((Zr_{1-z}Ti_{z})_{1-y} Ni_{y})O_{3-y+x/2}◊_{y-x/2},
wobei 0≤a<1, 0<x<1, 0<y<1, 0<z<1 ist, a für einen Überschuss an PbO in der Einwaage steht, □ eine Pb-Leerstelle und ◊ eine O-Leerstelle darstellt.

2. Keramikmaterial nach Anspruch 1,
bei dem das Bleizirkonat-Titanat die allgemeine Zusammensetzung ABO₃ eines Perowskitgitters aufweist,
wobei A für die A-Plätze und B für die B-Plätze des Perowskitgitters stehen.

3. Elektrokeramisches Bauelement, umfassend
ein Keramikmaterial nach einem der vorangegangenen Ansprüche.

4. Elektrokeramisches Bauelement nach Anspruch 3, ausgebildet als piezoelektrischer Aktuator.

5. Piezoelektrischer Aktuator nach Anspruch 4,
umfassend mindestens zwei Schichten umfassend ein Keramikmaterial nach einem der Ansprüche 1 bis 2, und eine Innenelektrode zwischen diesen Schichten.

6. Verfahren zur Herstellung eines Keramikmaterials nach einem der Ansprüche 1 bis 2, umfassend folgende Schritte,
A1) Herstellung eines Keramik-Rohstoffgemisches durch Zerkleinern und Mischen von Ausgangsmaterialien enthaltend Pb, Zr, Ti, Nd und Sauerstoff,
B1) Einbringen von Ni oder einer Ni-haltigen Verbindung,
C1) Kalzinieren des Rohstoffgemisches,
D1) Sintern zur Keramik.

7. Verfahren nach Anspruch 6,
wobei die Zugabe von Nd in einem Bereich von 0,01 bis 6 mol% erfolgt.

8. Verfahren nach einem der Ansprüche 6 bis 7,
wobei das Einbringen von Ni oder einer Ni-haltigen Verbindung vor dem Kalzinieren im Verfahrensschritt C1) erfolgt.

9. Verfahren nach einem der Ansprüche 6 bis 7,
wobei das Einbringen von Ni oder einer Ni-haltigen Verbindung nach dem Kalzinieren im Verfahrensschritt C1) erfolgt.

10. Verfahren nach einem der Ansprüche 6 bis 9,
wobei die Zugabe von Ni in einem Bereich von 0,01 bis 6 mol% erfolgt.

11. Verfahren nach einem der Ansprüche 6 bis 10,
wobei vor den Verfahrensschritten D1) aus dem einen Binder umfassenden Keramik-Rohstoffgemisch keramische Grünfolien geformt werden.

12. Verfahren zur Herstellung eines elektrokeramischen Vielschichtbauelements, umfassend,
A2) Bereitstellen von keramischen Grünfolien gemäß dem Verfahren nach Anspruch 11,
B2) Übereinanderschichten der keramischen Grünfolien zu einem Stapel,
C2) Verfestigen des Stapels durch Laminieren, wodurch Grünteile entstehen,
D2) Entbindern der Grünteile,
E2) Sintern der Grünteile.

13. Verfahren zur Herstellung eines Vielschichtbauelements, umfassend ein Keramikmaterial gemäß den Ansprüchen 1 bis 2, umfassend
A3) Herstellen eines Keramik-Rohstoffgemisches durch Zerkleinern und Mischen von Ausgangsmaterialien enthaltend Pb, Zr, Ti, Nd und Sauerstoff,
B3) Kalzinieren des Keramik-Rohstoffgemisches,
C3) Zugabe eines Binders zu dem Keramik-Rohstoffgemisch aus B3),
D3) Formen von Grünfolien aus dem Gemisch aus C3),
E3) Bedrucken der Grünfolien aus D3) mit Innenelektroden, wobei das Material der Innenelektroden Ni umfasst,
F3) Übereinanderschichten von einer Vielzahl der keramischen Grünfolien aus E3) zu einem Stapel,
G3) Verfestigen des Stapels durch Laminieren, wodurch Grünteile entstehen,
H3) Entbindern der Grünteile,
I3) Sintern der Grünteile, wobei ein Teil des Ni aus den Innenelektroden in das Keramikmaterial übergeht und in dieses eingebaut wird.

14. Verfahren nach Anspruch 13,
wobei das Material der Innenelektroden metallisches Ni oder Ni-Oxid umfasst.

## Claims

1. Ceramic material comprising lead zirconate titanate, which additionally contains Nd and Ni, having a composition according to the following formulae:
- for
y ≤ x/2: a PbO + (Pb_{1-3x/2+y}O_{x/2-y}Ndₓ) ((Zr_{1-z}Ti_{z})_{1-y}Ni_{y})O₃,
- for
y > x/2: a PbO + (Pb₁₋ₓNdₓ) ((Zr_{1-z}Ti_{z})_{1-y}Ni_{y})O_{3-y+x/2}◊_{y-x/2},
where 0≤a<1, 0<x<1, 0<y<1, 0<z<1, a stands for an excess of PbO in the weigh-in, □ represents a Pb vacancy and 0 represents an O vacancy.

2. Ceramic material according to Claim 1, in which the lead zirconate titanate has the general composition ABO₃ of a perovskite lattice, where A stands for the A sites and B stands for the B sites of the perovskite lattice.

3. Electro-ceramic component, comprising a ceramic material according to either of the preceding claims.

4. Electro-ceramic component according to Claim 3, configured as a piezoelectric actuator.

5. Piezoelectric actuator according to Claim 4, comprising at least two layers comprising a ceramic material according to one of Claims 1 to 2, and an inner electrode between these layers.

6. Method for producing a ceramic material according to one of Claims 1 to 2, comprising the following steps
A1) producing a ceramic raw material mixture by comminuting and mixing starting materials containing Pb, Zr, Ti, Nd and oxygen,
B1) introducing Ni or an Ni compound,
C1) calcining the raw material mixture,
D1) sintering the ceramic.

7. Method according to Claim 6, wherein Nd is added in a range of from 0.01 to 6 mol%.

8. Method according to one of Claims 6 to 7, wherein the introduction of Ni or an Ni compound is carried out before the calcining in a method step C1).

9. Method according to one of Claims 6 to 7, wherein the introduction of Ni or an Ni compound is carried out after the calcining in a method step C1).

10. Method according to one of Claims 6 to 9, wherein Ni is added in a range of from 0.01 to 6 mol%.

11. Method according to one of Claims 6 to 10, wherein before method step D1), ceramic green sheets are formed from the ceramic raw material mixture comprising a binder.

12. Method for producing a multilayer electro-ceramic component, comprising
A2) providing ceramic green sheets according to the method according to Claim 11,
B2) layering the ceramic green sheets on one another to form a stack,
C2) consolidating the stack by lamination, so as to create green parts,
D2) debindering the green parts,
E2) sintering the green parts.

13. Method for producing a multilayer component, comprising a ceramic material according to Claims 1 to 2, comprising
A3) producing a ceramic raw material mixture by comminuting and mixing starting materials containing Pb, Zr, Ti, Nd and oxygen,
B3) calcining the ceramic raw material mixture,
C3) adding a binder to the ceramic raw material mixture of B3),
D3) forming green sheets from the mixture of C3),
E3) printing inner electrodes on the green sheets of D3), the material of the inner electrodes comprising Ni,
F3) layering the ceramic green sheets of E3) on one another to form a stack,
G3) consolidating the stack by lamination, so as to create green parts,
H3) debindering the green parts,
I3) sintering the green parts, some of the Ni being transferred from the inner electrodes into the ceramic material and being incorporated in it.

14. Method according to Claim 13, wherein the material of the inner electrodes comprises metallic Ni or Ni oxide.

## Revendications

1. Matériau céramique comprenant du zirconate-titanate de plomb, qui contient en outre du Nd et du Ni, présentant une composition selon les formules suivantes :
- pour
y ≤ x/2 : aPbO + (Pb_{1-3x/2+y}□_{x/2-y}Ndₓ)((Zr_{1-z}Ti_{z})_{1-y}Ni_{y})O₃,
- pour
y > x/2 : aPbO + (Pb₁₋ₓNdₓ) ((Zr_{1-z}Tiz)_{1-y}Ni_{y})O_{3-y+x/2}O_{y-x/2},
dans lesquelles 0 ≤ a < 1, 0 < x < 1, 0 < y < 1, 0 < z < 1, a représente un excès de PbO dans la pesée de l'échantillon, □ représente une lacune de Pb et ◊ représente une lacune de O.

2. Matériau céramique selon la revendication 1, dans lequel le zirconate-titanate de plomb présente la composition générale ABO₃ d'un réseau de pérovskite, A représentant les sites A et B les sites B du réseau de pérovskite.

3. Composant électrocéramique, comprenant un matériau céramique selon l'une quelconque des revendications précédentes.

4. Composant électrocéramique selon la revendication 3, réalisé sous forme d'actionneur piézoélectrique.

5. Actionneur piézoélectrique selon la revendication 4, comprenant au moins deux couches comprenant un matériau céramique selon l'une quelconque des revendications 1 à 2 et une électrode interne entre ces couches.

6. Procédé pour la fabrication d'un matériau céramique selon l'une quelconque des revendications 1 à 2, comprenant les étapes suivantes, consistant à :
A1) préparer un mélange de matières premières céramiques par broyage et mélange de matières de départ contenant du Pb, du Zr, du Ti, du Nd et de l'oxygène,
B1) introduire du Ni ou un composé contenant du Ni,
C1) calciner le mélange de matières premières,
D1) fritter en céramique.

7. Procédé selon la revendication 6, l'addition de Nd étant réalisée dans une plage de 0,01 à 6% en mole.

8. Procédé selon l'une quelconque des revendications 6 à 7, l'introduction de Ni ou d'un composé contenant du Ni ayant lieu avant la calcination dans l'étape de procédé C1).

9. Procédé selon l'une quelconque des revendications 6 à 7, l'introduction de Ni ou d'un composé contenant du Ni ayant lieu après la calcination dans l'étape de procédé C1).

10. Procédé selon l'une quelconque des revendications 6 à 9, l'addition de Ni étant réalisée dans une plage de 0,01 à 6% en mole.

11. Procédé selon l'une quelconque des revendications 6 à 10, des ébauches de feuilles céramiques étant formées avant l'étape de procédé D1) à partir du mélange de matières premières céramiques comprenant un liant.

12. Procédé pour la fabrication d'un composant multicouche électrocéramique, consistant à
A2) mettre à disposition des ébauches de feuilles céramiques selon le procédé selon la revendication 11,
B2) superposer les ébauches de feuilles céramiques de manière à former une pile,
C2) solidifier la pile par laminage, des ébauches de pièces se formant,
D2) éliminer le liant des ébauches de pièces,
E2) fritter les ébauches de pièces.

13. Procédé pour la fabrication d'un composant multicouche comprenant un matériau céramique selon l'une quelconque des revendications 1 à 2, consistant à :
A3) préparer un mélange de matières premières céramiques par broyage et mélange de matières de départ contenant du Pb, du Zr, du Ti, du Nd et de l'oxygène,
B3) calciner le mélange de matières premières céramiques,
C3) ajouter un liant au mélange de matières premières céramiques de B3),
D3) former des ébauches de feuilles à partir du mélange de C3)
E3) imprimer les ébauches de feuilles de D3) avec les électrodes internes, le matériau des électrodes internes comprenant du Ni,
F3) superposer une multitude d'ébauches de feuilles céramiques de E3) de manière à former une pile,
G3) solidifier la pile par laminage, des ébauches de pièces se formant,
H3) éliminer le liant des ébauches de pièces,
I3) fritter les ébauches de feuilles, une partie du Ni passant des électrodes internes dans le matériau céramique et étant incorporée dans celui-ci.

14. Procédé selon la revendication 13, le matériau des électrodes internes comprenant du Ni métallique ou de l'oxyde de Ni.
